Europäisches Patentamt

European Patent Office

Office européen des brevets

(19)

(11) **EP 1 130 633 A1**

(12) **EUROPEAN PATENT APPLICATION**

(43) Date of publication:
**05.09.2001 Bulletin 2001/36**

(51) Int Cl.[7]: **H01L 21/314, C23C 16/30**

(21) Application number: **00830152.5**

(22) Date of filing: **29.02.2000**

(84) Designated Contracting States:
**AT BE CH CY DE DK ES FI FR GB GR IE IT LI LU MC NL PT SE**
Designated Extension States:
**AL LT LV MK RO SI**

(71) Applicant: **STMicroelectronics S.r.l.**
**20041 Agrate Brianza (Milano) (IT)**

(72) Inventors:
 • **Vulpio, Michele**
  **70050 Santo Spirito, BA (IT)**
 • **Gerardi, Cosimo**
  **72027 San Pietro Vernotico, BR (IT)**

(74) Representative: **Botti, Mario**
  **Botti & Ferrari S.r.l.**
  **Via Locatelli, 5**
  **20124 Milano (IT)**

(54) **A method of depositing silicon oxynitride polimer layers**

(57)     The invention relates to a method of depositing polymeric layers of silicon oxynitride onto a surface of a semiconductor material substrate by a CVD (Chemical Vapor Deposition) technique using at least one chemical precursor. The innovative aspect lies essentially in that an organosilane is used as a chemical precursor.

More particularly, the organosilane comprises a combination of silicon (Si), nitrogen (N), carbon (C) and hydrogen (H).

$$CH_3 - \underset{\underset{CH_3H}{|}}{\overset{\overset{CH_3}{|}}{Si}} - \underset{\underset{}{|}}{N} - \underset{\underset{CH_3}{|}}{\overset{\overset{CH_3}{|}}{Si}} - CH_3$$

**Fig. 1**

EP 1 130 633 A1

## Description

Field of the Invention

This invention relates to a method of depositing polymeric layers of silicon oxynitride onto a semiconductor by a CVD (Chemical Vapor Deposition) technique, useful to the fabrication of integrated electronic circuits by the VLSI (Very Large Scale Integration) technique.

Prior Art

As is known, silicon oxynitride is a highly important material to the insulating technology currently employed for fabricating VLSI electronic circuits. Films of this oxynitride are also widely used for outer passivating layers to protect devices formed on a semiconductor from contamination. Other possible applications include glare preventing coatings for solar cells, and the thin active dielectrics used in VLSI-CMOS technology.

Some methods are known from literature and currently practiced for depositing films of silicon oxide ($SiO_2$) and oxynitride ($Si_2O_6N$) using such CVD techniques as SACVD (Sub-Atmospheric CVD), PECVD (Plasma Enhanced Chemical Vapor Deposition), LPCVD (Low Pressure CVD), APCVD (Atmospheric Pressure CVD), and HDP-CVD (High Density Plasma CVD). Chemicals compounds known as precursors are used to initiate the film depositing process; such compounds must contain the chemical elements that are to form the chemical backbone of the finished film.

For depositing films of silicon oxide, there are used either precursors based on compounds containing an organic part and an inorganic part and known as organosilanes, or silane ($SiH_4$) and oxygen ($O_2$). Typical organosilanes containing an organic part are HMDSN (hexamethyldisilazane) and HMDSO (hexamethyldisiloxane), having the group $CH_3$ as their organic part, and TEOS (tetraethylorthosilicate) having the group $CH_3CH_2$ as its organic part. These compounds are used, in particular, with the SACVD, PECVD and LPCVD techniques. Silane and oxygen are used with the APCVD, LPCVD and HDP-CVD techniques.

For depositing oxynitride films, mixtures of silane ($SiH_4$) and nitrogen dioxide ($N_2O$) are used, and for plasma deposition, ammonia ($NH_3$) and nitrogen ($N_2$) are used.

However, the use of silane gas has several drawbacks. Silane is a dangerous gas and produces film unevenness. In addition, the high reaction temperatures involved in a CVD process frequently harm the substrate, especially where the finished films are used as pre-metallization (PMD) or inter-metallization (IMD) dielectric layers, or as dielectric layers in VLSI circuits. Moreover, the reactions are very slow in all of the above instances.

A method of depositing silicon oxynitride by PECVD is described in US Patents No.s 4,599,678 (granted to Wertheimer et al. on July 8, 1986) and 4,673,588 (granted to Bringmann et al. on June 16, 1987 and assigned to U. S. Philips Corp.).

The former of these documents discloses a thin film of oxynitride dielectric deposited by PECVD. The deposition is initiated using HMDSO and HMDSN as precursors.

The latter document relates to a method of applying polymeric coatings to a substrate by PECVD depositing polymerizable gas HMDSN. This gas is preferred because it is far less toxic than the silane gas usually employed in deposition processes. And its use offers additional advantages. It is reported by Hieber et al. (US Patent No. 5,399,389) that, for depositing silicon oxide ($SiO_2$) films, the use of HMDSO, which is very similart to HMDSN, as a precursor instead of TEOS improves the rate of deposition. Many other references point to these monomers yielding films which exhibit improved physical characteristics, such as a higher density, with respect to films formed from silane.

However, PECVD deposition is affected by some significant problems, such as uncontrolled film stoichiometry and plasma damaging, which greatly restrict the application of such a method to all metallization levels.

Thus, there exists a need to use in the electronic industry compounds which areless toxic and technically more convenient.

The technical problem underlying this invention is to suggest a method for depositing films of silicon oxynitride using a technique and a chemical precursor effective to yield a uniform film and provide for improved processing conditions.

Summary of the Invention

The concept of this invention is to deposit a layer of silicon oxynitride through the CVD technique using HMDSN as the precursor.

It has been found that, whereas the deposition of oxynitride by $SiH_4$, $N_2O$ and $NH_3$ activated CVD requires very high temperatures (about 900°C) process, the deposition with CVD techniques of oxynitride activated by HMDSN can be carried out at a much lower temperature (e.g., about 550°C using the SACVD, Sub-Atmospheric CVD technique).

In essence, the method of this invention entails the use of HMDSN as a CVD deposition precursor.

Based on this concept, the technical problem is solved by a method as previously indicated and defined in the characterizing part of Claim 1.

The features and advantages of a method according to the invention will be apparent from the following description of an embodiment thereof, given by way of example and not of limitation.

## Detailed Description

The process steps and the structures described herein below are not exhaustive of a process for fabricating integrated circuits. This invention can be practiced, in fact, together with integrated circuit fabrication techniques currently employed in the industry, and only such conventional process steps as are deemed necessary to an understanding of the invention will be discussed.

This method enables films of silicon oxynitride to be deposited by a CVD technique and using hexamethyldisilazane ($Si_2NC_4H_{19}$) monomer gas, also known by its acronym HMDSN, as a chemical precursor. In this monomer, the nitrogen atom is strongly bonded to the two silicon atoms by that the free electron pair of the nitrogen atoms can be shared with the silicon atoms. Since silicon, has "d" orbitals free, it can stabilize this bond through another resonant structure wherein the nitrogen atom shares the electron pair with the silicon atoms. [This structure weakens the N-H bond which will be, therefore, weaker than the N-H bond of ammonia. This is confirmed by the fact that the proportion of N-H bonds in plasma-formed films using this monomer is always quite small.] A possible embodiment of the inventive method is the HMDSN exploitation as a precursor in ozone-activated SACVD. In this case, the reaction stoichiometry is:

$$4\ HMDSN + 43\ O_2 \rightarrow 24\ CO_2 + 38\ H_2O + 4\ [Si_2N]$$

This reaction yields a deposition precursor wherein silicon atoms are allowed to react with oxygen radicals, provided in the reaction, to yield a film of silicon oxynitride.

Thus, the use of HMDSN leads to a faster deposition process and an increased density of the deposited film. It is known (e.g., from US Patent No. 5,399,389) that where silicon oxide ($SiO_2$) films are to be deposited, the use of HMDSO as a precursor instead of TEOS enhances the rate of deposition. Furthermore, it is reported in several' articles that the HMDSN and HMDSO monomers yield films with improved physical characteristics, such as a superior quality and uniformity of the film compared to films deposited by a conventional technique using TEOS.

Moreover, the deposition process can be run at a lower temperature and higher deposition rate by virtue of the structure of HMDSN containing two silicon atoms instead of the single atom of TEOS.

In addition, the inventive method can be easily implemented in the process steps made available by conventional VLSI technology, using some typical process parameters. In particular, the chemicals used are HMDSN, $N_2O$ or $O_3$, $N_2$ and $O_2$. The process temperature and pressure are within the range of 550° to 1000°C, and 0.1 to 3 bar, respectively. The rate of deposition of the film onto silicon varies between 0.5 and 200 nm/minute.

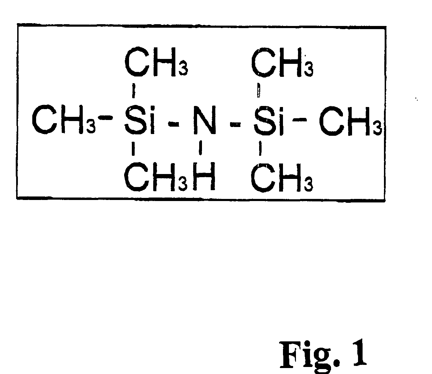

## Claims

1. A method of depositing polymeric layers of silicon oxynitride onto a surface of a semiconductor material substrate by a CVD (Chemical Vapor Deposition) technique using at least one chemical precursor, **characterized in that** said chemical precursor is an organosilane.

2. A method according to Claim 1, **characterized in that** said organosilane comprises a combination of silicon (Si), nitrogen (N), carbon (C) and hydrogen (H).

3. A method according to Claim 1, **characterized in that** said organosilane is HMDSN.

4. A method according to Claim 3, **characterized in that** said HMDSN is used at a process temperature above 400°C.

5. A method according to Claim 4, **characterized in that** said process temperature is in the 400° to 1000°C range.

6. A method according to Claim 3, **characterized in that** said HMDSN is used at a process pressure of 0.1 to 3 bar.

7. A method according to Claim 3, **characterized in that** the rate of deposition during the depositing step is in the range of 0.5 to 200 nm/minute.

8. A method according to Claims 1 and 3, **characterized in that** said HMDSN is used as the precursor of a SACVD (Sub-Atmospheric CVD) technique activated by an oxygen compound.

9. A method according to Claim 8, **characterized in that** said oxygen compound is ozone.

$$CH_3-\overset{\displaystyle \overset{CH_3}{|}}{\underset{\displaystyle \underset{CH_3H}{|}}{Si}}-\overset{\displaystyle \underset{|}{N}}{}-\overset{\displaystyle \overset{CH_3}{|}}{\underset{\displaystyle \underset{CH_3}{|}}{Si}}-CH_3$$

Fig. 1

**European Patent Office**

## EUROPEAN SEARCH REPORT

Application Number

EP 00 83 0152

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (Int.Cl.7) |
| X | WO 99 11573 A (DAWSON ELLI DAVID F ;TRUESDALE CARLTON M (US); CORNING INC (US)) 11 March 1999 (1999-03-11) * the whole document * | 1-6,8 | H01L21/314 C23C16/30 |
| X | FREEMAN D ET AL: "PROPERTIES OF LOW-PRESSURE CHEMICAL VAPOR DEPOSITED DIELECTRIC FILMS FROM HEXAMETHYLDISILAZANE" JOURNAL OF VACUUM SCIENCE AND TECHNOLOGY: PART A,US,AMERICAN INSTITUTE OF PHYSICS. NEW YORK, vol. 7, no. 3, PART 01, 1 May 1989 (1989-05-01), pages 1446-1450, XP000126093 ISSN: 0734-2101 * the whole document * | 1-5,8 | |
| X | GONZALEZ-LUNA R ET AL: "Deposition of silicon oxinitride films from hexamethyldisilizane (HMDS) by PECVD" PREPARATION AND CHARACTERIZATION,NL,ELSEVIER SEQUOIA, vol. 317, no. 1-2, 1 April 1998 (1998-04-01), pages 347-350, XP004147678 ISSN: 0040-6090 * the whole document * | 1-5 | TECHNICAL FIELDS SEARCHED (Int.Cl.7) H01L C23C |
| A | PATENT ABSTRACTS OF JAPAN vol. 018, no. 499 (E-1607), 19 September 1994 (1994-09-19) & JP 06 168930 A (NEC CORP), 14 June 1994 (1994-06-14) * abstract * | 1,8,9 | |

The present search report has been drawn up for all claims

| Place of search | Date of completion of the search | Examiner |
|---|---|---|
| THE HAGUE | 21 July 2000 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 00 83 0152

This annex lists the patent family members relating to the patent documents cited in the above-mentioned European search report.
The members are as contained in the European Patent Office EDP file on
The European Patent Office is in no way liable for these particulars which are merely given for the purpose of information.

21-07-2000

| Patent document cited in search report | Publication date | Patent family member(s) | Publication date |
|---|---|---|---|
| WO 9911573 A | 11-03-1999 | AU 8694298 A | 22-03-1999 |
| JP 06168930 A | 14-06-1994 | JP 2684942 B<br>US 5593741 A | 03-12-1997<br>14-01-1997 |

EPO FORM P0459

For more details about this annex : see Official Journal of the European Patent Office, No. 12/82